# EUROPEAN PATENT APPLICATION

(11) **EP 4 239 671 A1**
(43) Date of publication of application: **06.09.2023**
(21) Application number: 21888100.1
(22) Date of filing: 11.05.2021
(51) Int. Cl.: H01L 23/473

(54) **PHASE CHANGE LIQUID COOLING HEAT DISSIPATION DEVICE**

(30) Priority: 03.11.2020 CN 202011208539
(71) Applicant: Thero New Material Technology Co., Ltd, Shenzhen, Guangdong 518000 (CN)
(72) Inventor: NIE, Xin, Shenzhen, Guangdong 518000 (CN); YANG, Ruohan, Shenzhen, Guangdong 518000 (CN); WANG, Yongheng, Shenzhen, Guangdong 518000 (CN)
(74) Representative: Murgitroyd & Company
(86) International application number: PCT/CN2021/093025
(87) International publication number: WO 2022/095397

(57) **Abstract**

Aphase-change liquid cooling heat dissipation device includes from top to bottom: a phase-change energy storage module (1), a water cooling module (2), and a heat conduction cavity (3), wherein a top and a bottom of a heat absorption mechanism (7) of the water cooling module (2) are fixedly mounted respectively to the phase-change energy storage module (1) and the heat conduction cavity (3), and the heat conduction cavity (3) is mounted to a CPU (4). The heat conduction cavity (3) is filled with water and a ratio of a volume of the water within the heat conduction cavity (3) to a volume of the heat conduction cavity (3) is 0.2~0.9, and the heat conduction cavity (3) is made of red copper. The phase-change energy storage module (1) is filled with a phase-change material. This solves a technical problem of failure in using a computer normally due to CPU therein failing to dissipate heat rapidly in an overload state which degrades performance of the CPU and shorten a service life of the CPU.

## Description

### TECHNICAL FIELD

The present application relates to electronic temperature control technologies, and more particularly, to a heat dissipation device in a computer, and more particularly, to a phase-change liquid cooling heat dissipation device for dissipating heat for CPU in an overload state.

### BACKGROUND

A central processing unit (CPU) is one of core electronic components of a computer. With increasing demand for computer capabilities as well as the rapid development of various large-scale software and games, a computing load of the CPU is increasing. Power consumption by the CPU has reached about 80W. A high-power and high-frequency computer will cause the temperature of CPU to increase, which may shorten a service life of the CPU and degrade performance of the CPU.

Anormal operating temperature of the CPU is generally maintained between 45°C-55°C. A heat dissipation device in a conventional computer is mainly composed of heat dissipation aluminum and a fan. In use, a power source is used to drive the fan to realize rapid heat dissipation, which results in large electric energy and high power. Importantly, when the CPU exceeds a state in which the heat dissipation device can dissipate heat, that is, when the heat dissipation device cannot satisfy overheating of the CPU, sometimes the CPU may continue working in an overload state, so that the heat generated by the CPU may cause the temperature of the CPU to exceed a predetermined temperature and the heat dissipation fan cannot quickly take away the heat, which causes the CPU to work at a relatively high temperature, thereby degrading the performance of the CPU and shortening the service life of the CPU. The present disclosure solves a technical problem that a computer cannot be used normally because the CPU in the computer cannot rapidly dissipate heat in the overload state which degrades the performance of the CPU and shorten the service life of the CPU. As to the above problem, no effective solution has been proposed at present.

### SUMMARY

### Technical problem

A main objective of the present application is to provide a phase-change liquid cooling heat dissipation device, so as to solve a technical problem that a computer cannot be used normally because a CPU in the computer cannot rapidly dissipate heat in an overload state which degrades performance of the CPU and shorten a service life of the CPU. The present disclosure can effectively solve the technical problem that the CPU cannot be quickly dissipated in an overloaded working state, and can effectively prevent damage to the CPU caused by a failure to dissipate heat timely in an overheated state.

### Technical solutions

In order to achieve the above obj ective, according to one aspect of the present application, there is provided a phase-change liquid cooling heat dissipation device. The phase-change liquid cooling heat dissipation device includes from top to bottom: a phase-change energy storage module, a water cooling module, and a heat conduction cavity, wherein a top and a bottom of a heat absorption mechanism of the water cooling module are fixedly mounted respectively to the phase-change energy storage module and the heat conduction cavity, and the heat conduction cavity is mounted to a CPU; wherein the heat conduction cavity is filled with water and a ratio of a volume of the water within the heat conduction cavity to a volume of the heat conduction cavity is 0.2~0.9, and the heat conduction cavity is made of copper; and the phase-change energy storage module is filled with a phase-change material. The heat conduction cavity transmits heat to the water cooling module mainly through liquid water in the heat conduction cavity and a wall of the heat conduction cavity. Between the phase-change energy storage module and the heat conduction cavity is mainly the heat absorption mechanism of the water cooling module, which dissipates heat through the heat dissipation mechanism of the water cooling module after heat absorption. When an overload state occurs to the CPU, the phase-change energy storage module starts to function, and the phase-change material in the phase-change energy storage module can absorb heat. When the CPU recovers to a normal state, the phase-change material releases heat into the water cooling module, and recovers to a normal state, thereby functioning as buffering protection at a peak time of the CPU in the overload state. The heat conduction cavity is filled with water and a ratio of a quantity of the filled water to a volume of the heat conduction cavity is 0.2~0.9. That is, there is liquid water and an air layer in the heat conduction cavity. After the liquid water is evaporated, heat is transmitted to the water cooling module through water vapor, so that efficiency is higher. The heat conduction cavity is made of red copper. The red copper has good heat conductivity, is not easy to rust, has long usage time, and has good durability. The top and the bottom of the heat absorption mechanism of the water cooling module are respectively fixedly mounted on the phase-change energy storage module and the heat conduction cavity by strong glue attaching, which of course does not limit other fixing methods. The water cooling module may also be referred to as a liquid cooling module.

Preferably, the phase-change energy storage module includes an enclosed energy storage cavity and a first thermal fin, wherein the first thermal fin is arranged in the energy storage cavity and the energy storage cavity is filled with the phase-change material.

Preferably, the first thermal fin is integrally formed with the energy storage cavity.

Preferably, the phase-change material in the phase-change energy storage module adopts a phase-change material having a phase-change point within 56~75°C, and further preferably a phase-change material having a phase-change point within 56~65°C. Of course, in the present disclosure, the phase-change material is selected according to a CPU normal temperature and a CPU limit temperature. Generally, the phase-change point of the phase-change material is 5~10°C higher than the CPU normal operating temperature. A regular CPU normal operation temperature is 45~55°C. Therefore, the phase-change material having the phase-change point within 56~65°C is selected.

Preferably, the water cooling module includes the heat absorption mechanism, a coolant pump, and a heat dissipation mechanism. The heat absorption mechanism is configured to absorb heat transferred from the heat conduction cavity, the heat absorption mechanism, the coolant pump, and the heat dissipation mechanism are connected by a hose, and the coolant pump drives water in the heat absorption mechanism and water in the heat dissipation mechanism to circulate.

Preferably, the heat absorbing mechanism includes a heat transfer cavity and a second thermal fin, wherein the second thermal fin is fixed inside the heat transfer cavity, and the heat transfer cavity is made of red copper and filled with liquid water. The heat absorption mechanism is mainly configured to absorb the heat transferred from the heat conduction cavity.

Preferably, a temperature sensor is provided in the heat transfer cavity of the heat absorption mechanism. The temperature sensor can measure the heat in the heat absorption mechanism to adjust a gear of a fan in the heat dissipation mechanism.

Preferably, the heat dissipation mechanism includes a third thermal fin, a metal pipe, and the fan, wherein the metal pipe is filled with liquid water and the fan is configured to release heat from the third thermal fin and the metal pipe into air.

Preferably, the third thermal fin is a W-shaped thermal fin. The W-shaped thermal fin dissipates heat more rapidly.

Preferably, the ratio of the volume of the water within the heat conduction cavity to the volume of the heat conduction cavity is 0.4~0.6, and an air pressure within the heat conduction cavity is less than 1.01×10 ⁵Pa. That is, the air in the heat conduction cavity is pumped to a low pressure, which is less than the standard atmospheric pressure, thereby reducing a temperature at which the liquid water vaporizes. In a heat transfer process, the water in the heat conduction cavity continuously vaporizes and liquefies, and continuously absorbs and releases heat, thereby improving overall heat dissipation and heat conduction efficiency.

A basic working process of the phase-change liquid cooling heat dissipation device is as follows: when a CPU temperature increases, transferring heat to the water cooling module through the liquid water and water vapor in the heat conduction cavity, and dissipating heat through the water cooling module. Under the circumstances that the temperature exceeds heat dissipation capacity of the water cooling module, when the CPU is in the overload state and the temperature exceeds the phase-change point of the phase-change material in the phase-change energy storage module, the phase-change energy storage module starts to work and the phase-change material liquefies, thereby rapidly absorbing a large amount of heat and preventing the water cooling module from heating up. When the CPU returns to a normal load, the water cooling module also returns to a normal temperature region below the phase-change point. As the temperature decreases, the liquefied phase-change material releases heat to re-solidify, returns the heat absorbed at the peak time to the water cooling module, and dissipates heat in the air through the heat dissipation mechanism of the water cooling module. In this process, the phase-change material absorbs or releases a part of the heat through phase change to prevent the CPU temperature from rising, thereby protecting a stable operation of a system.

### Beneficial effect

The present application utilizes a three-layer structure of the phase-change energy storage module, the water cooling module, and the heat conduction cavity. A function generated by the phase-change energy storage module reduces the CPU temperature when the CPU is in an overloaded state, thereby allowing the CPU to work normally at a normal temperature. This solves a technical problem that the computer cannot be used normally because the CPU in the computer cannot rapidly dissipate heat in the overload state which degrades the performance of the CPU and shorten the service life of the CPU.

### BRIEF DESCRIPTION OF THE DRAWINGS

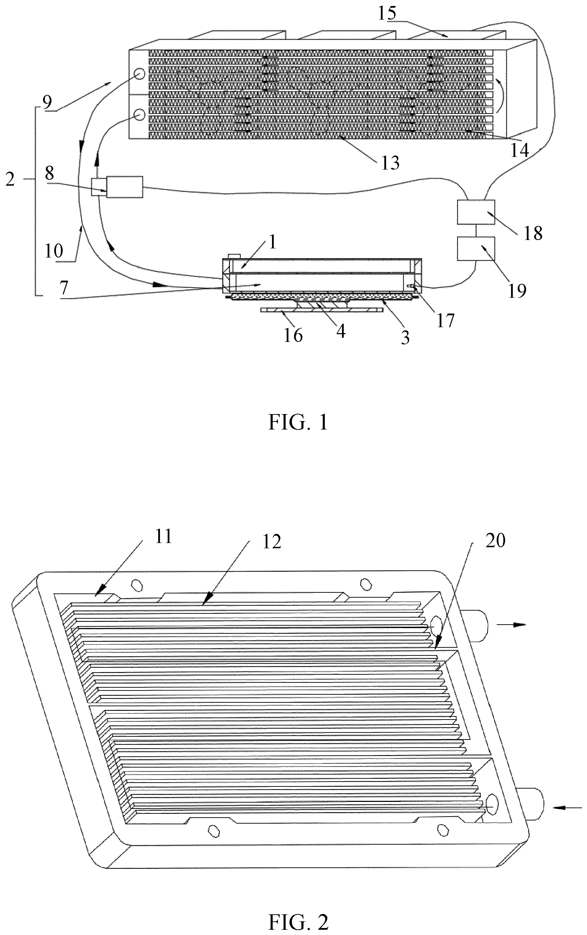

The accompanying drawings, which form a part of the present application, serve to provide a further understanding of the present application and to make other features, objects, and advantages of the present application more apparent. The drawings and description of illustrative embodiments thereof serve to explain the present application and are not to be construed as undue limiting to the present application.
In the drawings: FIG. 1 is a schematic diagram of a structure of a phase-change liquid cooling heat dissipation device according to the present application.
FIG. 2 is a schematic diagram of an internal structure of a heat absorption mechanism of the phase-change liquid cooling heat dissipation device according to an embodiment of the present application.
FIG. 3 is a schematic diagram of an internal structure of a phase-change energy storage module of the phase-change liquid cooling heat dissipation device according to an embodiment of the present application.

List of reference numerals in the drawings: 1- phase-change energy storage module; 2- water cooling module; 3- heat conduction cavity; 4- CPU; 5- energy storage cavity; 6- first thermal fin; 7- heat absorption mechanism; 8- coolant pump; 9- heat dissipation mechanism; 10- hose; 11- heat transfer cavity; 12- second thermal fin; 13-third thermal fin; 14- metal pipe; 15- fan; 16- main board; 17- temperature sensor; 18-power supply; 19- control panel; 20- guide isolation plate.

### DETAILED DESCRIPTION

In order to make those skilled in the art understand the present disclosure better, technical solutions of embodiments in the present application will be described clearly and completely in connection with the drawings of the present application hereinafter. Obviously, the described embodiments are merely part of embodiments of the present application, not all embodiments thereof. Based on the embodiments in the present application, all other embodiments obtained by a person having ordinary skill in the art without involving any inventive effort shall fall within the protection scope of the present application.

It should be noted that the terms "first", "second", and the like in the specification, claims, and the above-mentioned drawing of the present application are used to distinguish similar objects, and are not necessarily used to describe a specific order or a sequence. It is to be understood that the data used in such manner may be interchanged as appropriate, for convenience of describing the embodiments of the present application. Furthermore, the term "including" is intended to cover non-exclusive inclusion.

In the present application, orientations or position relationships indicated by the terms "on" and "under" are based on orientations or position relationships shown in the drawings. These terms are mainly intended to better describe the present application and the embodiments thereof, and are not intended to limit a particular orientation in which indicated devices or components must be oriented.

Also, other than the orientations or the position relationships, a part of the above-mentioned terms may be used to represent other meanings. For example, the term "on" may also be used in some cases to indicate a certain attachment relationship or connection relationship. The person having ordinary skill in the art may understand specific meanings of these terms in the present application according to specific circumstances.

Furthermore, the terms "mounting", "setting", "providing", "connection", "linking", and "socketing" are to be understood in a broad sense, which, for example, may be a fixed connection, a detachable connection, or an integral construction, or may be directly connected or indirectly connected through an intermediary, or may be internal connection between two devices, elements, or components. The person having ordinary skill in the art may understand specific meanings of these terms in the present application according to specific circumstances.

It should be noted that the embodiments in the present application and the features in the embodiments may be combined with each other without conflict. The present application will now be described in detail with reference to the accompanying drawings and embodiments.

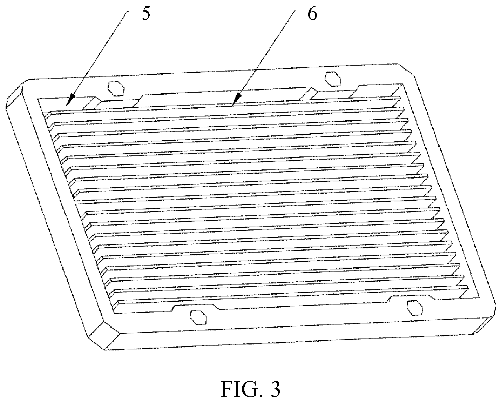

As shown in FIGS. 1-3, the present application relates to a phase-change liquid cooling heat dissipation device. The phase-change liquid cooling heat dissipation device includes from top to bottom: a phase-change energy storage module 1, a water cooling module 2, and a heat conducting cavity 3. A top and a bottom of a heat absorption mechanism 7 of the water cooling module are fixedly respectively mounted to the phase-change energy storage module and the heat conducting cavity, and the heat conducting cavity is mounted to the CPU. The heat conduction cavity is filled with water and a ratio of a volume of the water within the heat conduction cavity to a volume of the heat conduction cavity is 0.2~0.9. The heat conduction cavity is made of copper. The phase-change energy storage module is filled with a phase-change material. The heat conduction cavity transmits heat to the water cooling module mainly through liquid water in the heat conduction cavity and a wall of the heat conduction cavity. Between the phase-change energy storage module and the heat conduction cavity is mainly the heat absorption mechanism of the water cooling module, which dissipates heat through the heat dissipation mechanism of the water cooling module after heat absorption. When an overload state occurs to the CPU, the phase-change energy storage module starts to function, and the phase-change material in the phase-change energy storage module can absorb heat. When the CPU recovers to a normal state, the phase-change material releases heat into the water cooling module, and recovers to a normal state, thereby functioning as buffering protection at a peak time of the CPU in the overload state. The heat conduction cavity is filled with the water and the ratio of the volume of the water within the heat conduction cavity to the volume of the heat conduction cavity is 0.2~0.5. That is, there is liquid water and an air layer in the heat conduction cavity. After the liquid water is evaporated, heat is transmitted to the water cooling module through water vapor, so that efficiency is higher. The heat conduction cavity is made of red copper. The red copper has good heat conductivity, is not easy to rust, has long usage time, and has good durability. The CPU is mounted on a main board 16.

As shown in FIGS. 1-3, the phase-change energy storage module includes an enclosed energy storage cavity 5 and a first thermal fin 6. The first thermal fin is arranged in the energy storage cavity and the phase-change material is filled in the energy storage cavity. The first thermal fin is integrally formed with the energy storage cavity.

A phase-change point of the phase-change material in the phase-change energy storage module is 59°C. The phase-change material having the phase-change point of 59°C ensures a normal and efficient operation of the CPU. A CPU normal operation temperature range is 45°C-55°C. When the phase-change point exceeds 59°C, the phase-change accumulator functions.

As shown in FIGS. 1-3, the water cooling module includes the heat absorption mechanism 7, a coolant pump 8, and a heat dissipation mechanism 9. The heat absorption mechanism is configured to absorb heat transferred from the heat conducting cavity. The heat absorption mechanism, the coolant pump, and the heat dissipation mechanism are connected by a hose 10. The coolant pump drives water in the heat absorption mechanism and water in the heat dissipation mechanism to circulate. The coolant pump 8 is electrically connected to a power supply 18. The power supply is electrically connected to a control panel 19. The control panel is configured to control a gear of the fan and a switch of the coolant pump. A temperature sensor 17 is electrically connected to the control panel. The control panel is electrically connected to the power supply.

As shown in FIG. 2, the heat absorption mechanism includes a heat transfer cavity 11 and a second thermal fin 12. The second thermal fin is fixed inside the heat transfer cavity, liquid water is filled in the heat transfer cavity, and the heat transfer cavity is made of red copper. The heat absorption mechanism is mainly configured to absorb the heat transferred from the heat conduction cavity. Also provided in FIG. 2 are two guide isolation plates 20, a length of which is smaller than a length of the second thermal fin. A main function of the guide isolation plates is liquid water backflow.

A temperature sensor may be provided in the heat transfer cavity of the heat absorption mechanism. The temperature sensor can measure heat in the heat absorption mechanism to adjust a gear of a fan in the heat dissipation mechanism through the control panel. The temperature sensor is electrically connected to the control panel. When the temperature sensor exceeds the normal temperature, the gear of the fan is adjusted to accelerate an operation of the fan and improve heat dissipation capability.

As shown in FIGS. 1-3, the heat dissipation mechanism includes a third thermal fin 13, a metal pipe 14, a fan 15, and the control panel. The control panel is a miniature controller. Liquid water is filled in the metal pipe. The fan releases heat from the third thermal fin and the metal pipe into the air. The third thermal fin is a "W-shaped" heat dissipation device. The W-shaped thermal fin dissipates heat more rapidly.

As shown in FIG. 1, an air pressure within the heat conduction cavity is smaller than 0.8×10⁵ Pa. That is, the air in the heat conduction cavity is pumped to a low pressure, which is less than the standard atmospheric pressure, thereby reducing a temperature at which the liquid water vaporizes. In a heat transfer process, the water in the heat conduction cavity continuously vaporizes and liquefies, and continuously absorbs and releases heat, thereby improving overall heat dissipation and heat conduction efficiency.

A basic working process of the phase-change liquid cooling heat dissipation device is as follows: when a CPU temperature increases, transferring heat to the water cooling module through the liquid water and water vapor in the heat conduction cavity, and dissipating the heat through the water cooling module. Under the circumstances that the temperature exceeds heat dissipation capacity of the water cooling module, when the CPU is in the overload state and the temperature exceeds the phase-change point of the phase-change material in the phase-change energy storage module, the phase-change energy storage module starts to work and the phase-change material liquefies, thereby rapidly absorbing a large amount of heat and preventing the water cooling module from heating up. When the CPU returns to a normal load, the water cooling module also returns to a normal temperature region below the phase-change point. As the temperature decreases, the liquefied phase-change material releases heat to re-solidify, returns the heat absorbed at the peak time to the water cooling module, and dissipates heat in the air through the heat dissipation mechanism of the water cooling module. In this process, the phase-change material absorbs or releases a part of the heat through phase change to prevent the CPU temperature from rising, thereby protecting a stable operation of a system.

This embodiment utilizes a three-layer structure of the phase-change energy storage module, the water cooling module, and the heat conduction cavity. A function of the phase-change energy storage module reduces the CPU temperature when the CPU is in an overloaded state, thereby allowing the CPU to work normally at a normal temperature. This solves a technical problem that a computer cannot be used normally because a CPU in the computer cannot rapidly dissipate heat in an overload state which degrades performance of the CPU and shorten a service life of the CPU.

The above are merely preferred embodiments of the present application, and are not intended to limit the present application. Various modifications and variations may occur to those skilled in the art. Any modifications, equivalents, variations, etc. within the spirit and principles of the present application are intended to fall within the scope of the present application.

## Claims

1. A phase-change liquid cooling heat dissipation device, comprising a phase-change energy storage module (1), a water cooling module (2), and a heat conduction cavity (3),
wherein a top and a bottom of a heat absorption mechanism (7) of the water cooling module are fixedly mounted respectively to the phase-change energy storage module and the heat conduction cavity;
the heat conduction cavity is attachable to a CPU (4);
the heat conduction cavity is filled with water, a ratio of a volume of the water within the heat conduction cavity to a volume of the heat conduction cavity being 0.2~0.9, and the heat conduction cavity being made of red copper; and
the phase-change energy storage module (1) is filled with a phase-change material.

2. The phase-change liquid cooling heat dissipation device of claim 1, wherein the phase-change energy storage module (1) comprises an enclosed energy storage cavity (5) and a first thermal fin (6) arranged in the energy storage cavity, and the energy storage cavity is filled with the phase-change material.

3. The phase-change liquid cooling heat dissipation device of claim 2, wherein the first thermal fin (6) is integrally formed with the energy storage cavity.

4. The phase-change liquid cooling heat dissipation device of claim 1, wherein:
the water cooling module comprises the heat absorption mechanism (7), a coolant pump (8), and a heat dissipation mechanism (9),
wherein the heat absorption mechanism is configured to absorb heat transferred by the heat conduction cavity, the heat absorption mechanism, the coolant pump, and the heat dissipation mechanism are connected by a hose (10), and the coolant pump is configured to drive water in the heat absorption mechanism and water in the heat dissipation mechanism to circulate.

5. The phase-change liquid cooling heat dissipation device of claim 4, wherein the heat absorption mechanism comprises a heat transfer cavity (11) and a second thermal fin (12) fixed inside the heat transfer cavity, and the heat transfer cavity (11) is made of red copper and filled with liquid water.

6. The phase-change liquid cooling heat dissipation device of claim 5, wherein a temperature sensor (17) is provided in the heat transfer cavity of the heat absorption mechanism.

7. The phase-change liquid cooling heat dissipation device of claim 4, wherein the heat dissipation mechanism comprises a third thermal fin (13), a metal pipe (14), and a fan (15); the metal pipe is filled with liquid water; and the fan is configured to release heat from the third thermal fin and the metal pipe into air.

8. The phase-change liquid cooling heat dissipation device of claim 7, wherein the third thermal fin is a W-shaped thermal fin.

9. The phase-change liquid cooling heat dissipation device of claim 1, wherein the ratio is 0.4~0.6, and an air pressure within the heat conduction cavity is less than 1.01×10⁵ Pa.
